# EUROPÄISCHE PATENTSCHRIFT

(11) **EP 3 601 849 B1**
(45) Veröffentlichungstag und Bekanntmachung des Hinweises auf die Patenterteilung: **27.12.2023**
(21) Anmeldenummer: 18715520.5
(22) Anmeldetag: 20.03.2018
(51) Int. Cl.: F16H 59/70, F16H 63/32, F16H 63/30, F16H 59/68

(54) **VORRICHTUNG UND VERFAHREN ZUR POSITIONSERFASSUNG EINER SCHALTGABEL EINES SCHALTGETRIEBES**
DEVICE AND METHOD FOR SENSING THE POSITION OF A SHIFT FORK OF A TRANSMISSION
DISPOSITIF ET PROCÉDÉ PERMETTANT DE DÉTECTER LA POSITION D'UNE FOURCHETTE DE BOÎTE DE VITESSES ET BOÎTE DE VITESSES

(30) Priorität: 24.03.2017 DE 102017002873
(43) Veröffentlichungstag der Anmeldung: 05.02.2020
(73) Patentinhaber: ZF CV Systems Europe BV, 1170 Brussels (BE)
(72) Erfinder: GROETZINGER, Stefan, 30989 Gehrden (DE); JOHN, Michael, 31275 Lehrte (DE); MÜNTEFERING, Dirk, 30900 Wedemark (DE); POUX, Romain, 30163 Hannover (DE)
(74) Vertreter: Rabe, Dirk-Heinrich
(86) Internationale Anmeldenummer: PCT/EP2018/056960
(87) Internationale Veröffentlichungsnummer: WO 2018/172323

(56) Entgegenhaltungen:
- WO-A1-2009/052976
- DE-A1- 19 924 995
- DE-A1-102006 011 207
- DE-A1-102009 042 998
- DE-B3- 10 336 971
- DE-C1- 10 150 955
- JP-A- 2013 029 138

## Beschreibung

Die Erfindung betrifft eine Vorrichtung mit einer Hall-Sensoreinrichtung zur Positionserfassung einer Schaltgabel in einem Schaltgetriebe, wobei die Schaltgabel mit einer Kolbenstange eines in einem Schaltzylinder axial beweglich geführten Schaltkolbens wirkverbundenen ist sowie in eine axial verschiebbar auf einer Getriebewelle angeordnete Schiebemuffe eingreift, um diese Schiebemuffe zum Ein- oder Auslegen einer Übersetzungsstufe des Schaltgetriebes zu verschieben. Außerdem betrifft die Erfindung ein Verfahren zur Positionserfassung einer Schaltgabel in einem Schaltgetriebe mit einer solchen Vorrichtung.

Die Steuerung eines automatisierten Schaltgetriebes erfordert zum Wechsel zwischen verschiedenen Übersetzungsstufen eine Information über den jeweiligen aktuellen Gangwechselstatus. Dafür wird in der Regel eine Positionserfassung einer Schaltgabel beziehungsweise einer durch diese betätigten Schiebemuffe durchgeführt, wobei die Schiebemuffe zum Einlegen einer Übersetzungsstufe ein Gangrad mit einer Welle drehfest verbindet und dieses zum Auslegen der Übersetzungsstufe wieder löst. Die Position der Schaltgabel wird einer elektronischen Steuerungseinheit des Schaltgetriebes zur Verfügung gestellt, welche hieraus Schaltbefehle ermittelt und versendet.

Meistens erfolgt die Messung einer relevanten axialen Position eines diesbezüglichen Stellglieds über die Erfassung einer Linearbewegung einer Schaltschiene, Schubstange oder dergleichen mit einem rein linear messenden Sensor, wie beispielsweise einem induktiven Messsystem oder einem auf dem Hall-Effekt beruhenden einfachen Hall-Sensor. Soll die Schaltgabelbewegung beziehungsweise Schaltgabelposition direkt gemessen werden, ist dies mit herkömmlichen Sensoren nur bei linear bewegten Schaltgabeln möglich. Für Getriebekonstruktionen, bei denen eine Schaltgabel zum Ein- oder Auslegen einer Übersetzungsstufe eine Schwenkbewegung ausführt, sind Linearsensoren kaum geeignet, da der Signalgeber nicht direkt an der Schaltgabel sondern nur an einem mit dieser zusammenwirkenden linear bewegten Stellglied, beispielsweise einer Kolbenstange oder einem Schaltkolben, angebracht werden kann.

Eine indirekte Positionserfassung einer verschwenkten Schaltgabel mit einem Linearsensor ist somit zwar an sich möglich, es hat sich allerdings herausgestellt, dass eine derartige Positionsmessung mit einem Signalgeber, welcher an einem mit einer Schaltgabel in Wirkverbindung stehenden Stellglied zum Betätigen der Schaltgabel angebracht ist, mit einer rein linearen Messmethode zu Problemen führen kann. Schon ein geringes konstruktions-, fertigungs-, oder verschleißbedingtes freies Spiel, welches sich in der Übertragungskette zwischen einem Stellglied, das dann den Signalgeber trägt, und der Schaltgabel, deren Position zu bestimmen ist, auswirkt, kann zu Messfehlern führen. Ein solches Spiel kann beispielsweise zwischen einem bewegten Schaltkolben oder einer bewegten Kolbenstange als Träger des Signalgebers und einem feststehenden Schaltzylinder, in dem der Schaltkolben geführt ist, auftreten. Dieses Spiel wird insbesondere dann relevant, wenn es zu einer Verdrehungsstellung des Signalgebers gegenüber dem Signalnehmer kommt, beispielsweise aufgrund einer Drehbewegung einer den Signalgeber tragenden Kolbenstange um deren Längsachse während ihrer axialen Stellbewegung zum Betätigen der Schaltgabel. Dies kann zu einem axialen Versatz des Sensorsignals gegenüber der tatsächlichen Schaltgabelposition oder zu Signalrauschen bis hin zum völligen Ausfall des Messsignals führen. Angestrebt wird daher die Möglichkeit einer direkten Positionserfassung verschwenkt oder linear bewegter Schaltgabeln und/oder die Möglichkeit einer betriebssicheren indirekten Positionserfassung solcher Schaltgabeln.

Es ist für bestimmte Fahrzeugfunktionen zur Positionserfassung von Komponenten bereits bekannt, in mehreren Dimensionen mehrere Linearsensoren, wie beispielsweise induktive Messsysteme oder einen integrierten Raumsensor, wie etwa einen 3D-Hall-Sensor einzusetzen. Aus der EP 1 438 755 B1 ist die Anordnung und Funktionsweise eines derartigen 3D-Hall-Sensors für die räumliche Erfassung von Magnetfeldern bekannt. Die DE 10 2009 015 883 A1 zeigt und beschreibt eine Vorrichtung zur Erfassung der Position eines Fahrstufenwählhebels mit einem an dem Fahrstufenwählhebel angeordneten Signalgeber und einem zu dem Signalgeber beabstandet angeordneten, als 3D-Hall-Sensor ausgebildeten Signalnehmer.

Aus der DE 10 2014 218 495 A1 ist eine Sensorvorrichtung für ein Schaltgetriebe zur Erfassung des Schaltzustands einer Schaltwelle bekannt, wobei ein als Magnet ausgebildeter Signalgeber auf der Schaltwelle angeordnet ist und ein als Hall-Sensor ausgebildeter Signalnehmer stationär befestigt ist. Bei einer Änderung der axialen Position des Signalgebers ergibt sich eine Änderung der Relativposition zwischen Signalgeber und Hall-Sensor. Der Signalgeber ist hierbei als ein Ringsegment oder als ein Ring ausgebildet ist.

Aus der DE 10 2008 058 163 A1 ist eine Vorrichtung zur Erfassung sämtlicher Schaltpositionen bei einem Schaltgetriebe, wie Neutralstellung, Rückwärtsgang und Zwischenpositionen, bekannt, bei der einem beweglichen Stellelement, wie einer Welle zur Übertragung von Schaltbewegungen, mindestens ein als Magnet ausgebildeter Signalgeber zugeordnet ist, und bei der mindestens zwei Hall-Elemente, wie beispielsweise zwei 3D-Hall-Sensoren, zur Bestimmung der Position des Stellelements vorgesehen sind. DE102006011207A1 betrifft eine Sensoranordnung zur Erfassung wenigstens einer Position eines beweglich gelagerten Elementes in einer Erfassungsrichtung, wobei die Sensoranordnung eine Magnetanordnung, die in der Erfassungsrichtung eine Magnetfeldverteilung besitzt, und einen Magnetfeldsensor aufweist, und wobei die Magnetanordnung wenigstens zwei Magnete aufweist, deren Magnetfeldverteilungen so miteinander kombiniert sind, dass sich zumindest über einen Abschnitt in Erfassungsrichtung eine annähernd lineare Kennlinie der Sensoranordnung ergibt.

WO2009052976A1 betrifft eine Sensorvorrichtung und ein Verfahren zur Ermittlung der Schaltstellung einer Schaltwelle sowie eine Getriebeschaltvorrichtung mit einer solchen Sensorvorrichtung.

DE102009042998A1 betrifft ein Halteelement zur Befestigung an einer sich in einer axialen Richtung erstreckenden Schaltstange. Ein derartiges Halteelement soll insbesondere der Befestigung von Schaltkomponenten auf einer Schaltstange dienen. Die DE10336971 B3 zeigt den Oberbegriff des Anspruchs 1 sowie den Oberbegriff des Verfahrensanspruchs 7. DE19924995 zeigt eine Positionserfassung eines Stellelements in einem Getriebe, bei welchem die Translationslage des Stellelements erfasst wird und Einflussgrößen aus Kipp- oder Drehbewegung unterdrückt werden.

Vor diesem Hintergrund lag der Erfindung die Aufgabe zugrunde, eine Vorrichtung zur Positionserfassung einer Schaltgabel in einem Schaltgetriebe vorzuschlagen, die in der Messgenauigkeit sowie Zuverlässigkeit verbessert ist und zugleich eine Kostensenkung bei der Getriebeherstellung ermöglicht. Eine weitere an die Erfindung gerichtete Aufgabe bestand darin, ein Verfahren zur Positionserfassung einer Schaltgabel in einem Schaltgetriebe mit einer solchen Vorrichtung anzugeben. Insbesondere soll eine solche Vorrichtung für ein automatisiertes Schaltgetriebe im Antriebsstrang eines Fahrzeugs geeignet sein.

Die Lösung dieser Aufgabe ergibt sich aus den Merkmalen der unabhängigen Ansprüche, während vorteilhafte Ausgestaltungen und Weiterbildungen der Erfindung den Unteransprüchen entnehmbar sind.

Der Erfindung lag die Erkenntnis zugrunde, dass in einem Schaltgetriebe ein herkömmlicher Positionssensor, welcher nur Linearbewegungen messen kann, nicht direkt an Schaltgabeln nutzbar ist, welche zur Betätigung einer Schiebemuffe verschwenkt werden müssen. Außerdem ist ein solcher herkömmlicher Positionssensor auch nur bedingt für solche Stellglieder geeignet, die zwar im Wesentlichen eine axiale Stellbewegung ausführen, jedoch auch noch andere, an sich unerwünschte Bewegungsfreiheitsgrade aufweisen können.

Ein 3D-Hall-Sensor ermöglicht hingegen sowohl die Messung von Linearbewegungen als auch die Erfassung von Kurven- und/oder Drehbewegungen eines auf einem Stellglied angebrachten Signalgebers relativ zum Sensor. Ein derartiger Sensor kann somit auch an solchen Stellgliedern genutzt werden, die dreidimensionale Bewegungen ausführen, da das Magnetfeld eines Signalgebers, welcher an dem betreffenden Stellglied befestigt ist und dessen Bewegung mitmacht, durch den 3D-Hall-Sensor in Abstand und Winkel räumlich aufgelöst werden kann. Dies ermöglicht es, die jeweilige axiale Stellung einer Schiebemuffe, welche bei Schaltvorgängen durch das Stellglied betätigt wird, exakt zu ermitteln, auch wenn die genannte Aktuatorik unter Verschleißerscheinungen leidet. Die Hall-Sensortechnik setzt dabei nicht voraus, dass sich das Target beziehungsweise das Magnetfeld während der Messung bewegt, also dass jederzeit, auch bei stehendem Stellglied, die Positionsbestimmung angefordert werden kann. Die Flexibilität verschiedener Anordnungsmöglichkeiten einer solchen Sensorik zur Positionserfassung erlaubt es zudem, die notwendige elektrische Verkabelung des Hall-Sensors aus einem Nassbereich des Getriebes in einen dazu benachbarten Trockenbereich zu verlagern.

Die Erfindung geht daher zunächst aus von einer Vorrichtung mit einer Hall-Sensoreinrichtung zur Positionserfassung einer Schaltgabel in einem Schaltgetriebe, wobei die Schaltgabel mit einer Kolbenstange eines in einem Schaltzylinder axial beweglich geführten Schaltkolbens wirkverbundenen ist sowie in eine axial verschiebbar auf einer Getriebewelle angeordnete Schiebemuffe eingreift, um diese Schiebemuffe zum Ein- oder Auslegen einer Übersetzungsstufe des Schaltgetriebes zu verschieben.

Zur Lösung der gestellten Aufgabe hinsichtlich der Schaffung einer Vorrichtung zur Positionserfassung einer Schaltgabel in einem Schaltgetriebe sieht die Erfindung vor, dass an der Schaltgabel ein einziger Magnet als Signalgeber angeordnet ist, dass ein relativ zu dem Magnet ortsfest angeordneter 3D-Hall-Sensor als Signalnehmer vorhanden ist, mittels dem ein durch den Magnet erzeugtes Magnetfeld räumlich erfassbar ist, dass der 3D-Hall-Sensor mit einer elektronischen Steuerungseinheit verbunden ist, und dass die Steuerungseinheit derart ausgebildet ist, dass mit dieser aus der jeweiligen Relativposition zwischen dem Magnet und dem 3D-Hall-Sensor die aktuelle Position der Schaltgabel bestimmbar sowie als Signal zur Verfügung stellbar ist, wobei lineare Bewegungen, rotatorische Bewegungen und/oder Schwenkbewegungen der Schaltgabel berücksichtigbar sind.

Die Anwendung der 3D-Hall-Technik in einem Schaltgetriebe ermöglicht demnach eine sehr flexible Anordnung eines Signalgebers in dem Getriebe, unabhängig davon, ob ein zu messendes Stellglied axial verschoben oder verschwenkt wird. Der Signalgeber kann somit direkt an dem betreffenden, aktuatorfernen Stellglied angebracht sein, wodurch sich schon per se eine verbesserte Messgenauigkeit ergibt, da keine Messfehler durch eine mechanische Übertragungskette entstehen können. Insbesondere können auch Kurvenbewegungen eines Stellglieds erfasst werden. Einfache lineare Messungen sind selbstverständlich auch möglich.

Die Erfindung ist ebenso vorteilhaft für Anordnungen geeignet, in denen der Signalgeber beispielsweise konstruktions- oder bauraumbedingt nicht direkt an dem zu messenden Stellglied angebracht werden kann oder soll. In diesen Fällen können Fehlereinflüsse oder Messsignalbeeinträchtigungen aufgrund von überlagerten linearen und nichtlinearen Bewegungen an einem Stellglied oder zwischen mehreren an der Stellaufgabe beteiligten Stellgliedern kompensiert werden, wie an den im Folgenden beschriebenen Ausführungsformen der Erfindung verdeutlicht wird. Dadurch wird eine zuverlässige und genaue Positionserfassung einer Schaltgabel sichergestellt. Insbesondere kann mit Hilfe des 3D-Hall-Sensors zuverlässig und exakt festgestellt werden, ob eine angesteuerte Schaltposition des Schaltgetriebes erreicht ist, selbst dann, wenn an dem Stellglied, an dem der Signalgeber angeordnet ist, Störeinflüsse bei der zu messenden Stellbewegung auftreten.

3D-Hall-Sensoren sind als kompakte Halbleiterbauteile in verschiedenen Ausführungen käuflich verfügbar. Da nur ein einziger 3D-Hall-Sensor als Signalnehmer für die Positionserfassung benötigt wird, kann zudem im Vergleich zu herkömmlichen Anordnungen, welche für räumliche Magnetfeldmessungen mehrere Sensoren benötigen, Bauraum eingespart werden. Zweckmäßigerweise kann der Sensor für den größtmöglichen Abstand zu einem Signalgeber im Getriebe ausgelegt werden. Dadurch ist der Sensor für verschiedene Montagepositionen geeignet und es sind keine aufwändigen Anpassungen an den jeweiligen Einbauort in einem vorhandenen Schaltgetriebe erforderlich. Dadurch können sich Fertigungs- und Entwicklungskosten verringern.

Der Schutzbereich wird durch die Patentansprüche bestimmt, wobei die Beschreibung und die Zeichnungen jedoch nur zur Auslegung der Patentansprüche heranzuziehen sind.

Gemäß einem nicht erfindungsgemäßen Beispiel kann vorgesehen sein, dass an der Kolbenstange oder an dem Schaltkolben ein Magnet angeordnet und derart ausgebildet ist, dass im Zusammenwirken mit einem zugeordneten 3D-Hall-Sensor eine Linearbewegung der Kolbenstange oder des Schaltkolbens erfassbar ist, und dass eine der Linearbewegung der Kolbenstange oder des Schalkolbens überlagerte lagerungsbedingte und/oder verschleißbedingte Drehbewegung der Kolbenstange oder des Schaltkolbens um deren Längsachse durch eine an einen maximal möglichen Verdrehwinkel gegenüber dem 3D-Hall-Sensor angepasste Dimensionierung des Magneten bei der Erfassung des Magnetfelds kompensierbar ist, oder dass eine derartige Störbewegung bei der Bestimmung der Position der Schaltgabel rechnerisch in dem Steuerungsgerät eliminierbar ist.

Demnach kann gemäß einer nicht erfindungsgemäßen Beispielerklärung der Signalgeber an der Kolbenstange oder an dem Schaltkolben eines Aktuators angebracht sein, welcher durch eine Getriebesteuerung zur Betätigung angesteuert wird und die Schaltgabel beispielsweise elektropneumatisch betätigt. Die Kolbenstange führt eine Linearbewegung aus, um die Schaltgabel mit einer Stellkraft zu beaufschlagen. Die Stellposition im Getriebe wird bei dieser Ausführungsform nicht direkt an der Schaltgabel sondern an dem Schaltkolben beziehungsweise an der Kolbenstange erfasst. Der Signalgeber ist also nicht auf der Schaltgabel sondern an dem Schaltkolben oder an der Kolbenstange befestigt.

Die Lagerung des Schaltkolbens erzeugt allerdings nicht selten eine gewisse Drehung desselben um seine Längsachse, welches die Messung der axialen Stellposition erschwert oder gar unmöglich macht. Zusätzlich kann es auch durch fertigungsbedingte Toleranzen und Verschleiß zu einer nicht vernachlässigbaren Drehtoleranz des Schaltkolbens kommen. Dadurch variiert die Winkelstellung zwischen dem Signalgeber und dem ortsfesten Signalnehmer. Dies könnte bei der Verwendung eines Linearsensors zu einem starken Signalrauschen oder gar zum Verlust des Messsignals führen. Der 3D-Hall-Sensor kann diese Drehung des Schaltkolbens jedoch messtechnisch kompensieren, da er einen Raumwinkelbereich des dort befestigten Magneten erfassen kann. Diese Kompensation ist dadurch möglich, dass der Signalgeber, also der Magnet, in seiner Größe ausreichend ausgelegt ist, so dass der Signalempfänger das Magnetfeld des Magneten auch bei einer geringen Drehung des Schaltkolbens beziehungsweise der Kolbenstange detektieren sowie ein ausreichend starkes beziehungsweise genaues Messsignal erzeugen kann. Dadurch kann eine Signalverschlechterung aufgrund der Lagertoleranz des Schaltkolbens beziehungsweise der Schaltstange verhindert werden. Diese Anpassung der Dimensionierung des Magneten kann die Genauigkeit der Positionsmessung der Schaltgabel verbessern.

Eine weitere Möglichkeit oder eine zusätzlich Maßnahme kann darin bestehen, einen Parameter festzulegen, welcher den im Betrieb möglicherweise auftretenden Drehwinkel des Schaltkolbens beziehungsweise der Kolbenstange sowie ein dazu zu erwartendes Messsignal miteinander korreliert. Daraus kann ein Korrekturfaktor berechnet werden, mit dem das Messsignal multipliziert wird. Dies kann im 3D-Hall-Sensor selbst oder in einer elektronischen Steuerungseinheit erfolgen, welche an den Sensor angeschlossen ist. Dadurch wird das Messsignal rechnerisch unabhängig von einer Drehung des Schaltkolbens beziehungsweise der Kolbenstange. Diese Maßnahme kann ebenfalls die Genauigkeit der Positionsmessung der Schaltgabel verbessern.

Außerdem kann gemäß einem nicht erfindungsgemäßen Beispiel vorgesehen sein, dass der Magnet auf der Mantelfläche der Kolbenstange befestigt oder in einer taschenförmigen Ausnehmung der Kolbenstange festsitzend integriert ist. Demnach kann der Magnet in seiner Funktion als Signalgeber einfach auf der Kolbenstange oder auf dem Schaltkolben aufgesetzt und befestigt sein. Es ist besonders vorteilhaft, obwohl es nicht durch den Wortlaut des ersten Anspruchs abgedeckt worden ist, den Magneten direkt in den Schaltkolben beziehungsweise in die Kolbenstange zu integrieren, so dass dessen Oberfläche einen Teil der Mantelfläche desselben bildet. Der Magnet kann beispielsweise als ein Ringsegment in eine entsprechende Ausnehmung der Kolbenstange eingefasst sein. Der Magnet nimmt dadurch keinen zusätzlichen Bauraum ein. Zudem wird durch die Integration des Magneten Material eingespart und die Masse des Schaltkolbens beziehungsweise der Kolbenstange nicht oder allenfalls unbedeutend erhöht. Außerdem wird durch die Integration des Magneten kein unerwünschtes Drehmoment auf die Bauteile ausgeübt.

Gemäß einer Ausführungsform der Erfindung kann vorgesehen sein, dass zum Ein- oder Auslegen einer Übersetzungsstufe des Schaltgetriebes eine Schwenkbewegung der Schaltgabel vorgesehen ist, und dass der an der Schaltgabel angeordnete Magnet derart ausgebildet ist, dass in Zusammenwirkung mit einem zugeordneten 3D-Hall-Sensor die aus der Schwenkbewegung der Schaltgabel resultierende Position der Schaltgabel bestimmbar ist.

Bei dieser Ausführungsform der Erfindung kann demnach der Signalgeber direkt auf einer Schaltgabel, welche zum Betätigen einer Schiebemuffe verschwenkt wird, angebracht sein. Der Signalgeber kann alternativ dazu in die Schaltgabel integriert sein. Der 3D-Hall-Sensor erfasst das Magnetfeld des Magneten bei der Schwenkbewegung der Schaltgabel und bestimmt daraus die Position der Schaltgabel und damit der Schiebemuffe, um den aktuellen Schaltzustand des Getriebes zu ermitteln und der Getriebesteuerung zur Verfügung zu stellen.

Eine direkte Befestigung des Magneten an der Schaltgabel hat außerdem den Vorteil, dass eine gebrochene Schaltgabel oder eine gebrochene Verbindung zwischen der Schaltgabel und der Kolbenstange nun durch die Sensorik erkannt und durch eine Fehlermeldung signalisiert werden kann, da die Schaltgabel sich in diesem Fall nicht bewegt, obwohl der Schaltkolben betätigt wird. Dadurch kann das Schaltgetriebe vor Schäden geschützt sowie gegebenenfalls geeignete Maßnahmen eingeleitet und somit die Betriebssicherheit erhöht werden.

Gemäß einer anderen Weiterbildung der Erfindung kann vorgesehen sein, dass zum Ein- oder Auslegen einer Übersetzungsstufe des Schaltgetriebes eine Linearbewegung der Schaltgabel vorgesehen ist, und dass der an der Schaltgabel angeordnete Magnet derart ausgebildet ist, dass in Zusammenwirkung mit einem zugeordneten 3D-Hall-Sensor die aus der Linearbewegung der Schaltgabel resultierende Position der Schaltgabel bestimmbar ist, wobei eine der Linearbewegung überlagerte nichtlineare Bewegung der Schaltgabel durch eine geeignete Dimensionierung des Magneten bei der Erfassung des Magnetfelds kompensierbar ist, oder dass eine derartige Störbewegung bei der Bestimmung der Position der Schaltgabel rechnerisch eliminierbar ist, wobei der einzige Magnet in seiner Größe ausreichend ausgelegt ist, so dass der Signalempfänger das Magnetfeld des Magneten auch bei einer geringen Drehung des Schaltkolbens beziehungsweise der Kolbenstange detektieren sowie ein ausreichend starkes beziehungsweise genaues Messsignal erzeugbar ist, und wobei eine Signalverschlechterung aufgrund der Lagertoleranz des Schaltkolbens beziehungsweise der Schaltstange verhindert wird.

Demnach kann die Vorrichtung gemäß der Erfindung bei beiden üblichen Bauformen der Schiebemuffenbetätigung, also entweder über eine Schaltgabelverschwenkung oder über eine Schaltgabelverschiebung, vorteilhaft genutzt werden. Die Vorrichtung kann direkt an der Schaltgabel deren Position messen oder indirekt über ein die Schaltgabel betätigendes Stellglied, unabhängig von der jeweiligen Art des Stellwegs der Schaltgabel. Dabei können Störeinflüsse, welche die Messung oder das Messsignal ungünstig beeinträchtigen, mittels der 3D-Hall-Messtechnik im Steuerungsgerät oder auch schon in der Elektronik des 3D-Hall-Sensors ausgefiltert werden.

Gemäß einer weiteren Ausführungsform der Erfindung kann vorgesehen sein, dass der 3D-Hall-Sensor zumindest teilweise außerhalb eines Ölraums des Schaltgetriebes angeordnet ist. Dies kann dadurch konkretisiert sein, dass der 3D-Hall-Sensor einen Sensorkopf mit einer elektrischen Schnittstelle sowie einen mit dem Sensorkopf verbundenen Sensorfinger aufweist. Der Sensorfinger ragt dabei durch eine Gehäusewand in den Ölraum des Schaltgetriebes in Richtung zum zugeordneten Magneten hinein, und der Sensorkopf ist an einer Außenseite der Gehäusewand angeordnet sowie dort gegenüber dem Ölraum öldicht befestigt.

Die 3D-Hall-Sensoreinrichtung zur Schaltgabelpositionsmessung erlaubt flexible Möglichkeiten der Positionierung von Signalnehmer und zugehörigem Signalgeber in einem Schaltgetriebe. Insbesondere ist es möglich, den Signalnehmer aus dem Nassbereich des Getriebes zu entfernen, so dass sich zumindest der elektrische Anschluss des Signalnehmers in einem trockenen Bereich befindet. Der Sensorfinger kann in den Ölbereich hineinragen, um die Position des Signalgebers zu messen. Dadurch entfallen auch elektrische Leitungen für die Verkabelung des Sensors im Nassbereich des Getriebes, wo der zur Verfügung stehende Bauraum ohnehin oft recht gering ist. Der Aufwand für den elektrischen Sensorkontakt ist somit wesentlich geringer und weniger anfällig für Kabelschäden als bei konventionellen technischen Lösungen.

Gemäß einer weiteren Ausführungsform der Erfindung kann vorgesehen sein, dass der 3D-Hall-Sensor vollständig außerhalb des Ölraums des Schaltgetriebes angeordnet ist. Demnach ist es im Idealfall sogar möglich, die Position des Signalgebers durch eine aus einem nichtmagnetischen Material, wie beispielsweise Aluminium, bestehende Gehäusewand abzutasten. Beispielsweise kann bei Getriebestrukturen, bei denen der Abstand zwischen Signalgeber und Signalnehmer relativ klein und die Wandstärke des Gehäuses vergleichsweise gering gestaltet werden kann, eine ausreichende Signalstärke erreicht werden, die es ermöglicht, den Sensor komplett im Trockenbereich anzubringen. Dadurch entfallen sowohl elektrische Kabel innerhalb des Getriebegehäuses als auch Bohrungen und Dichtungen in Wandungen des Getriebegehäuse für den Sensor. Hierdurch kann der Aufwand für die Implementierung der 3D-Hall-Sensoreinrichtung zur Positionserfassung einer Schaltgabel beziehungsweise einer Schiebemuffe noch weiter verringert werden.

Außerdem betrifft die Erfindung ein Verfahren zur Positionsbestimmung einer Schaltgabel in einem Schaltgetriebe mittels einer Hall-Sensoreinrichtung, wobei die Schaltgabel mit einer Kolbenstange eines in einem Schaltzylinder axial beweglich geführten Schaltkolbens wirkverbundenen ist sowie in eine auf einer Getriebewelle axial verschiebbare Schiebemuffe eingreift, um diese zum Ein- oder Auslegen einer Übersetzungsstufe des Schaltgetriebes zu verschieben, und wobei an der Schaltgabel ein einziger Magnet der Hall-Sensoreinrichtung befestigt ist. Hierbei ist verfahrensgemäß vorgesehen, dass mittels eines ortsfesten 3D-Hall-Sensors das Magnetfeld des Magneten räumlich erfasst wird, welcher bei einer linearen, rotatorischen Stellbewegung und Schwenkbewegung der Schaltgabel mit diesen mitbewegt wird sowie dabei seine relative Lage zu dem ortsfesten 3D-Hall-Sensor verändert, und dass aus dem Sensorsignal des 3D-Hall-Sensors die aktuelle Position der Schaltgabel bestimmt wird.

Schließlich betrifft die Erfindung auch einen Aktuator für ein automatisiertes Schaltgetriebe eines Kraftfahrzeugs, welcher eine Vorrichtung zur Positionserfassung einer von diesem direkt oder indirekt zu betätigenden Schaltgabel des Schaltgetriebes aufweist, wobei diese Vorrichtung zumindest die Merkmale von wenigstens einem der zuvor geschilderten Vorrichtungsansprüche aufweist sowie zur Durchführung des beanspruchten Verfahrens ausgestaltet ist. Hierbei ist es vorteilhaft, wenn das Verfahren bei jedem Schaltvorgang und an jeder der an dem jeweiligen Schaltvorgang aktiv beteiligten Schaltgabeln durchgeführt wird. Dadurch ist stets eine einwandfreie Schaltsteuerung des Schaltgetriebes gewährleistet.

Die Erfindung wird nachstehend anhand von in der beigefügten Zeichnung dargestellten Ausführungsbeispielen näher erläutert. In der Zeichnung zeigt
Fig. 1 einen schematischen Ausschnitt eines Schaltgetriebes und eines Schaltaktuators mit einer Hall-Sensoreinrichtung gemäß nicht erfindungsgemäßen Beispielerklärung,
Fig. 2 zeigt die nicht erfindungsgemäße Hall-Sensoreinrichtung gemäß der genannten Beispielerklärung von Fig. 1 in einem schematisch vereinfachten sowie vergrößerten Querschnitt, und
Fig. 3 eine schematische Darstellung einer Ausführungsform einer Hall-Sensoreinrichtung gemäß der Erfindung.

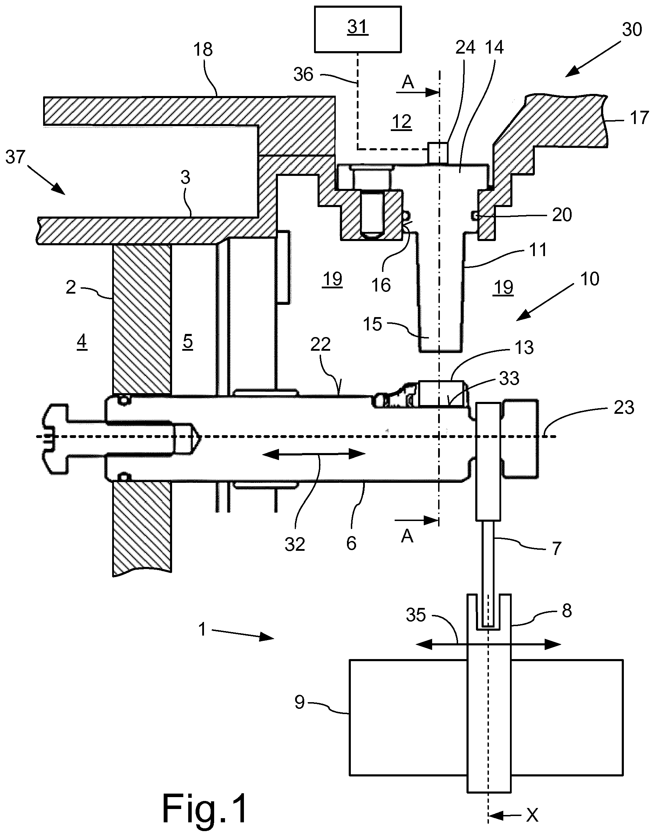

Einige Bauelemente in den Figuren stimmen in ihrem Aufbau und/oder in ihrer Funktion überein, so dass diese zur Vereinfachung mit denselben Bezugsziffern bezeichnet sind. Demnach zeigt Fig. 1 schematisch einen Ausschnitt eines automatisierten Schaltgetriebes 1 mit einer Getriebewelle 9, auf der eine Schiebemuffe 8 axial beweglich angeordnet ist. Die Schiebemuffe 8 ist mit einer Schaltgabel 7 verbunden, die von einem Schaltaktuator 37 betätigbar ist. Der Schaltaktuator 37 weist einen Schaltkolben 2 auf, der in einem Schaltzylinder 3 axial verschiebbar geführt ist. Der Schaltkolben 2 trennt einen ersten Druckraum 4 und einen zweiten Druckraum 5 voneinander. Die beiden Druckräume 4, 5 sind mit einem Druckmittel befüllbar beziehungsweise von diesem entleerbar, so dass der Schaltkolben 2 wechselseitig, beispielsweise pneumatisch, betätigbar ist. An dem Schaltkolben 2 ist eine Kolbenstange 6 befestigt. Die möglichen linearen Bewegungsrichtungen 32 des Schaltkolbens 2 und der Kolbenstange 6 koaxial zu deren Längsachse 23 sind durch einen Doppelpfeil angedeutet.

Die Schaltgabel 7 ist mit ihrem einen Ende mit der Kolbenstange 6 verbunden und greift mit ihrem anderen Ende in eine Ringnut der Schiebemuffe 8 ein. Somit sind der Schaltkolben 2, die Kolbenstange 6, die Schaltgabel 7 und die Schiebemuffe 8 miteinander bewegungsgekoppelt. Bei einer Druckbeaufschlagung einer der beiden Druckräume 4, 5 wird durch die Axialbewegung des Schaltkolbens 2 über die Schaltgabel 7 die Schiebemuffe 8 in einer der beiden Axialrichtungen verstellt. In hier nicht dargestellter, jedoch an sich bekannter Weise wird beim Schalten eines Ganges des Schaltgetriebes die Schiebemuffe 8 mittels der Schaltgabel 7 über eine Schaltverzahnung eines Gangrads geschoben, wodurch das Gangrad drehfest mit der hier nur angedeuteten Getriebewelle 9 verbunden wird. Durch eine Schaltbewegung in der Gegenrichtung wird der eingelegte Gang wieder ausgelegt. Die lineare Schaltbewegung 35 der Schiebemuffe 9 ist durch einen Doppelpfeil angedeutet.

Das Schaltgetriebe 1 beziehungsweise der Schaltaktuator 37 weist eine Vorrichtung 30 mit einer Hall-Sensoreinrichtung 10 zur Erfassung der jeweiligen aktuellen Position X der Schaltgabel 7 auf. Die Position X der Schaltgabel 7 ist eindeutig mit der axialen Position der Schiebemuffe 8 und somit mit dem aktuellen Schaltzustand des Schaltgetriebes 1 verknüpft. Die Hall-Sensoreinrichtung 10 weist einen 3D-Hall-Sensor 11 und einen diesem zugeordneten Magnet 13 auf, wobei der Magnet 13 als Signalgeber und der 3D-Hall-Sensor 11 als Signalnehmer fungieren. Der Magnet 13 ist auf der radialen Mantelfläche 22 der Kolbenstange 6 benachbart zum Eingriffbereich der Schaltgabel 7 angeordnet und dort in einer Ausnehmung 33 befestigt.

Der 3D-Hall-Sensor 11 besteht aus einem Sensorkopf 14 sowie einem Sensorfinger 15, welcher mit dem Sensorkopf 14 zusammen ein Bauteil bildet. Der 3D-Hall-Sensor 11 ist in eine Bohrung 16 in einer Gehäusewand 17 eines Getriebegehäuses 18 eingesetzt, wobei der Sensorfinger 15 in einen als Ölraum 19 innerhalb des Getriebegehäuses 18 ausgebildeten Nassbereich hineinragt und mit seinem freien Ende in Richtung zum Magneten 13 zeigt. Der Sensorkopf 14 weist eine elektrische Schnittstelle 24 auf, die sich in einem Trockenbereich 12 außerhalb des Ölraumes 19 befindet. An diese elektrische Schnittstelle 24 ist eine Sensorleitung 36 angeschlossen, welche mit einem Steuerungsgerät 31 verbunden ist. Dieses Steuerungsgerät 31 befehligt unter Nutzung der vom 3D-Hall-Sensor 11 gelieferten Informationen unter anderem hier nicht dargestellte Schaltventile, welche wechselweise einen Druckmittelzustrom in die beiden Drückräume 4, 5 ermöglichen oder diese von dem Druckmittel entleeren. Zudem ist erkennbar, dass der 3D-Hall-Sensor 11 gegenüber der Gehäusewand 17 mittels einer als Dichtring ausgebildeten Dichtung 20 öldicht abgedichtet ist.

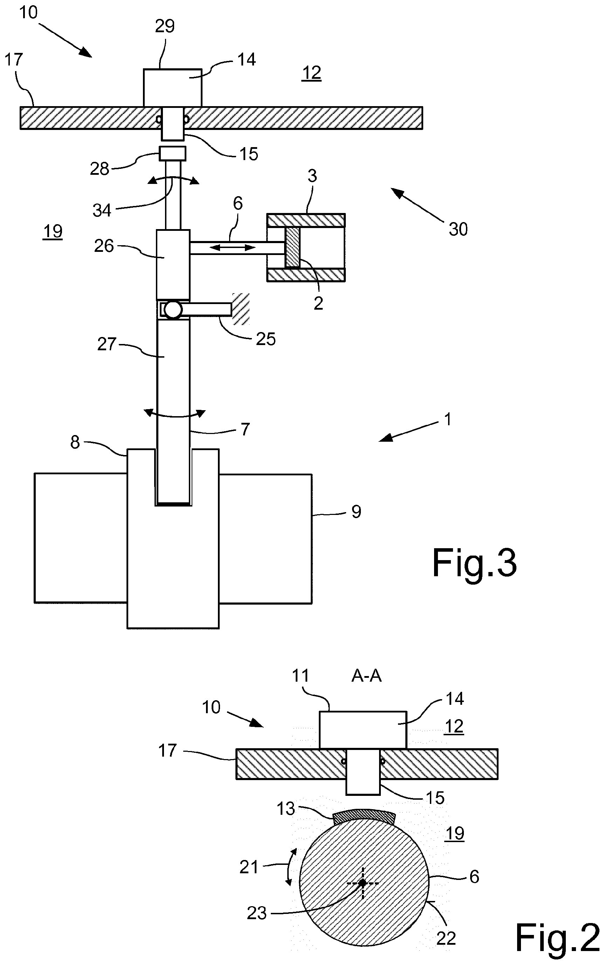

Wie aus Fig. 2 näher hervorgeht, schmiegt sich der Magnet 13 an der Mantelfläche 22 der Kolbenstange 6 formschlüssig an. Die Breite des Magneten 13 in Längsachsenrichtung der Kolbenstange 6 ist der gegenüberliegenden Breite des Sensorfingers15 angepasst (Fig. 1). Die Länge des Magneten 13 in Umfangsrichtung der Kolbenstange 6 ist hingegen an einem durch den Doppelpfeil angedeuteten Drehwinkel 21 der Kolbenstange 6 um deren Längsachse 23 angepasst (Fig. 2). Dadurch ist das Magnetfeld des Magneten 13 in jedem Fall ausreichend dimensioniert, um auch bei einer an sich unerwünschten Drehung der Kolbenstange 6 um einen Drehwinkel 21 von dem 3D-Hall-Sensor 11 erfasst zu werden.

Um die Position X der Schaltgabel 7 zu bestimmen, erfasst der 3D-Hall-Sensor 11 das Magnetfeld des Magneten 13. Die Hall-Spannung, welche an dem 3D-Hall-Sensor 11 abgegriffen werden kann, ist mit der Relativposition zwischen dem Sensorfinger 15 und dem Magnetfeld beziehungsweise zwischen dem Sensorfinger 15 und dem Magneten 13 eindeutig korreliert. Wenn sich bei einer Axialbewegung der Kolbenstange 6 diese ungewollt etwas dreht, kann dies bei einer hier nicht näher erläuterten vektoriellen Messung und Auswertung des Magnetfelds im 3D-Hall-Sensor 11 oder im Steuerungsgerät 31 kompensiert werden, so dass das Ergebnis der Positionsbestimmung der Schaltgabel 7 nicht durch die überlagerte Drehbewegung verfälscht oder in seiner Amplitudenhöhe geschwächt wird.

Fig. 3 zeigt eine erfindungsgemäße Ausführungsform. Die Kolbenstange 6 ist hierbei gelenkig mit der Schaltgabel 7 verbunden ist. Die Kolbenstange 6 drückt oberhalb eines Schwenklagers 25 auf ein Oberteil 26 der Schaltgabel 7 oder zieht an diesem, wodurch die Schaltgabel 7 verschwenkt wird. Ein Magnet 28 ist hier direkt am schaltmuffenfernen freien Ende der Schaltgabel 7 befestigt, und zwar unmittelbar benachbart zu einem 3D-Hall-Sensor 29. Mit ihrem Unterteil 27 greift die Schaltgabel 7 in eine Nut der Schiebemuffe 8 ein und verschiebt diese axial bei der beschriebenen Verschenkungsbewegung.

Der 3D-Hall-Sensor 29 kann die Kurvenbewegung der Schaltgabel 7 über die relative Lage beziehungsweise Lageänderung des Magnetfelds zum 3D-Hall-Sensor 29 messen und in eine axiale Position der Schaltgabel 7 beziehungsweise Schiebemuffe 8 umrechnen. Sofern eine sensorseitige Elektronik dazu nicht in der Lage ist, erfolgt diese Umrechnung in dem erwähnten Steuerungsgerät 31.

### Bezugszeichenliste (Bestandteil der Beschreibung)

- 1: Schaltgetriebe
- 2: Schaltkolben, Stellglied
- 3: Schaltzylinder
- 4: Erster Druckraum
- 5: Zweiter Druckraum
- 6: Kolbenstange, Stellglied
- 7: Schaltgabel, Stellglied
- 8: Schiebemuffe
- 9: Getriebewelle
- 10: Hall-Sensoreinrichtung
- 11: 3D-Hall-Sensor (erstes Ausführungsbeispiel)
- 12: Trockenbereich
- 13: Magnet (erstes Ausführungsbeispiel)
- 14: Sensorkopf
- 15: Sensorfinger
- 16: Bohrung
- 17: Gehäusewand
- 18: Getriebegehäuse
- 19: Ölraum
- 20: Dichtung
- 21: Drehwinkel
- 22: Mantelfläche
- 23: Längsachse
- 24: Elektrische Schnittstelle
- 25: Schwenklager
- 26: Oberteil der Schaltgabel
- 27: Unterteil der Schaltgabel
- 28: Magnet (zweites Ausführungsbeispiel)
- 29: 3D-Hall-Sensor (zweites Ausführungsbeispiel)
- 30: Vorrichtung mit einer Hall-Sensoreinrichtung
- 31: Steuerungseinheit
- 32: Lineare Bewegungsrichtung der Kolbenstange
- 33: Ausnehmung in der Kolbenstange
- 34: Schwenkbewegung der Schaltgabel
- 35: Lineare Bewegungsrichtung der Schaltgabel
- 36: Sensorleitung
- 37: Schaltaktuator
- X: Schaltgabelposition

## Patentansprüche

1. Vorrichtung (30) mit einer Hall-Sensoreinrichtung (10) zur Positionserfassung einer Schaltgabel (7) in einem Schaltgetriebe (1), wobei die Schaltgabel (7) mit einer Kolbenstange (6) eines in einem Schaltzylinder (3) axial beweglich geführten Schaltkolbens (2) wirkverbundenen ist sowie in eine axial verschiebbar auf einer Getriebewelle (9) angeordnete Schiebemuffe (8) eingreift, um diese Schiebemuffe (8) zum Ein- oder Auslegen einer Übersetzungsstufe des Schaltgetriebes (1) zu verschieben, wobei an der Schaltgabel (7) ein einziger Magnet (13, 28) als Signalgeber angeordnet ist, **dadurch gekennzeichnet, dass** ein relativ zu dem Magnet (13, 28) ortsfest angeordneter 3D-Hall-Sensor (11, 29) als Signalnehmer vorhanden ist, mittels dem ein durch den Magnet (13, 28) erzeugtes Magnetfeld räumlich erfassbar ist, dass der 3D-Hall-Sensor (11, 29) mit einer elektronischen Steuerungseinheit (31) verbunden ist, und dass die Steuerungseinheit (31) derart ausgebildet ist, dass mit dieser aus der jeweiligen Relativposition zwischen dem Magnet (13, 28) und dem 3D-Hall-Sensor (11, 29) die aktuelle Position der Schaltgabel (7) bestimmbar sowie als Signal zur Verfügung stellbar ist, wobei lineare Bewegungen, rotatorische Bewegungen und Schwenkbewegungen der Schaltgabel (7) berücksichtigbar sind.

2. Vorrichtung nach Anspruch 1, **dadurch gekennzeichnet, dass** zum Ein- oder Auslegen einer Übersetzungsstufe des Schaltgetriebes (1) eine Schwenkbewegung (34) der Schaltgabel (7) vorgesehen ist, und dass der an der Schaltgabel (7) angeordnete Magnet (28) derart ausgebildet ist, dass in Zusammenwirkung mit einem zugeordneten 3D-Hall-Sensor (29) die aus der Schwenkbewegung (34) der Schaltgabel (7) resultierende Position der Schaltgabel (7) bestimmbar ist.

3. Vorrichtung nach Anspruch 1 oder 2, **dadurch gekennzeichnet, dass** zum Ein- oder Auslegen einer Übersetzungsstufe des Schaltgetriebes (1) eine Linearbewegung (35) der Schaltgabel (7) vorgesehen ist, und dass der an der Schaltgabel (7) angeordnete Magnet (28) derart ausgebildet ist, dass in Zusammenwirkung mit einem zugeordneten 3D-Hall-Sensor (11) die aus der Linearbewegung der Schaltgabel (7) resultierende Position der Schaltgabel (7) bestimmbar ist, wobei eine der Linearbewegung überlagerte nichtlineare Bewegung der Schaltgabel (7) durch eine geeignete Dimensionierung des Magneten (28) bei der Erfassung des Magnetfelds kompensierbar ist, oder dass eine derartige Störbewegung bei der Bestimmung der Position der Schaltgabel (7) rechnerisch eliminierbar ist,
wobei der einzige Magnet (28) in seiner Größe ausreichend ausgelegt ist, so dass der Signalempfänger das Magnetfeld des Magneten (28) auch bei einer geringen Drehung des Schaltkolbens (2) beziehungsweise der Kolbenstange (6) detektieren sowie ein ausreichend starkes beziehungsweise genaues Messsignal erzeugbar ist, und wobei eine Signalverschlechterung aufgrund der Lagertoleranz des Schaltkolbens (2) beziehungsweise der Schaltstange verhindert wird.

4. Vorrichtung nach einem der Ansprüche 1 bis 3, **dadurch gekennzeichnet, dass** der 3D-Hall-Sensor (11, 29) zumindest teilweise außerhalb eines Ölraums (19) des Schaltgetriebes (1) angeordnet ist.

5. Vorrichtung nach Anspruch 4, **dadurch gekennzeichnet, dass** der 3D-Hall-Sensor (11, 29) einen Sensorkopf (14) mit einer elektrischen Schnittstelle (24) und einen mit dem Sensorkopf (14) verbundenen Sensorfinger (15) aufweist, wobei der Sensorfinger (15) durch eine Gehäusewand (17) in den Ölraum (19) des Schaltgetriebes (1) in Richtung zum zugeordneten Magneten (13, 28) hineinragt, und dass der Sensorkopf (14) an einer Außenseite der Gehäusewand (17) angeordnet sowie gegenüber dem Ölraum (19) öldicht befestigt ist.

6. Vorrichtung nach einem der Ansprüche 1 bis 4, **dadurch gekennzeichnet, dass** der 3D-Hall-Sensor (11, 29) vollständig außerhalb des Ölraums (19) des Schaltgetriebes (1) angeordnet ist.

7. Verfahren zur Positionsbestimmung einer Schaltgabel (7) in einem Schaltgetriebe (1) mittels einer Hall-Sensoreinrichtung (10), wobei die Schaltgabel (7) mit einer Kolbenstange (6) eines in einem Schaltzylinder (3) axial beweglich geführten Schaltkolbens (2) wirkverbundenen ist sowie in eine auf einer Getriebewelle (9) axial verschiebbare Schiebemuffe (8) eingreift, um diese zum Ein- oder Auslegen einer Übersetzungsstufe des Schaltgetriebes (1) zu verschieben, und wobei an der Schaltgabel (7) ein einziger Magnet (13, 28) befestigt ist, **dadurch gekennzeichnet, dass** mittels eines ortsfesten 3D-Hall-Sensors (11, 29) das Magnetfeld des Magneten (13, 28) räumlich erfasst wird, welcher bei einer linearen und rotatorischen Stellbewegung und bei einer Schwenkbewegung der Schaltgabel (7) mit diesen mitbewegt wird sowie dabei seine relative Lage zu dem ortsfesten 3D-Hall-Sensor (11, 29) verändert, und dass aus dem Sensorsignal des 3D-Hall-Sensors (11, 29) die aktuelle Position der Schaltgabel (7) bestimmt wird.

8. Aktuator (37) für ein automatisiertes Schaltgetriebe (1) eines Kraftfahrzeugs, welcher eine Vorrichtung (30) zur Positionserfassung einer von diesem direkt oder indirekt zu betätigenden Schaltgabel (7) des Schaltgetriebes (1) aufweist, wobei diese Vorrichtung (30) zumindest die Merkmale von einem der Ansprüche 1 bis 6 aufweist sowie zur Durchführung des Verfahrens nach Anspruch 7 ausgestaltet ist.

## Claims

1. Apparatus (30) comprising a Hall sensor device (10) for detecting the position of a shift fork (7) in a transmission (1), wherein the shift fork (7) is operatively connected to a piston rod (6) of a shifting piston (2) guided in an axially movable manner in a shift cylinder (3), and engages in a sliding sleeve (8), which is arranged on a transmission shaft (9) in an axially displaceable manner, in order to displace said sliding sleeve (8) for engaging or disengaging a transmission step of the transmission (1), wherein a single magnet (13, 28) is arranged on the shift fork (7) as a signal generator, **characterized in that** a 3D Hall sensor (11, 29) which is arranged in a stationary manner relative to the magnet (13, 28) is present as a signal receiver, by means of which a magnetic field generated by the magnet (13, 28) can be spatially detected, **in that** the 3D Hall sensor (11, 29) is connected to an electronic control unit (31), and **in that** the control unit (31) is designed in such a way that, by means of the control unit, the current position of the shift fork (7) can be determined from the relevant relative position between the magnet (13, 28) and the 3D Hall Sensor (11, 29) and provided as a signal, wherein linear movements, rotational movements, and pivoting movements of the shift fork (7) can be taken into account.

2. Apparatus according to claim 1, **characterized in that** a pivoting movement (34) of the shift fork (7) is provided for engaging or disengaging a transmission step of the transmission (1), and **in that** the magnet (28) arranged on the shift fork (7) is designed in such a way that, in cooperation with an associated 3D Hall sensor (29), the position of the shift fork (7) resulting from the pivoting movement (34) of the shift fork (7) can be determined.

3. Apparatus according to either claim 1 or claim 2, **characterized in that** a linear movement (35) of the shift fork (7) is provided for engaging or disengaging a transmission step of the transmission (1), and **in that** the magnet (28) arranged on the shift fork (7) is designed in such a way that, in cooperation with an associated 3D Hall sensor (11), the position of the shift fork (7) resulting from the linear movement of the shift fork (7) can be determined, wherein a non-linear movement of the shift fork (7) superposed on the linear movement can be compensated for by a suitable dimensioning of the magnet (28) during detection of the magnetic field, or **in that** a disturbing movement of this kind can be eliminated by calculation when determining the position of the shift fork (7),
wherein the single magnet (28) is of a sufficient size such that the signal receiver detects the magnetic field of the magnet (28), even in the case of a small rotation of the shifting piston (2) and/or the piston rod (6), and a sufficiently strong or accurate measurement signal can be generated, and wherein a signal degradation due to the bearing tolerance of the shifting piston (2) or the piston rod is prevented.

4. Apparatus according to any of claims 1 to 3, **characterized in that** the 3D Hall sensor (11, 29) is arranged at least partially outside an oil chamber (19) of the transmission (1).

5. Apparatus according to claim 4, **characterized in that** the 3D Hall sensor (11, 29) comprises a sensor head (14), having an electrical interface (24), and a sensor finger (15) connected to the sensor head (14), wherein the sensor finger (15) projects through a housing wall (17) into the oil chamber (19) of the transmission (1) in the direction of the associated magnet (13, 28), and **in that** the sensor head (14) is arranged on an outer side of the housing wall (17) and is fastened against the oil chamber (19) in an oil-tight manner.

6. Apparatus according to any of claims 1 to 4, **characterized in that** the 3D Hall sensor (11, 29) is arranged completely outside the oil chamber (19) of the transmission (1).

7. Method for determining the position of a shift fork (7) in a transmission (1) by means of a Hall sensor device (10), wherein the shift fork (7) is operatively connected to a piston rod (6) of a shifting piston (2) guided in an axially movable manner in a shift cylinder (3), and engages in a sliding sleeve (8) which is axially displaceable on a transmission shaft (9), in order to displace said sliding sleeve for engaging or disengaging a transmission step of the transmission (1), and wherein a single magnet (13, 28) is fastened to the shift fork (7), **characterized in that** the magnetic field of the magnet (13, 28) is spatially detected by means of a stationary 3D Hall Sensor (11, 29), which magnet, in the case of a linear and rotational actuating movement and a pivoting movement of the shift fork (7), is moved together with said shift fork and thereby changes its relative position to the stationary 3D Hall sensor (11, 29), and **in that** the current position of the shift fork (7) is determined from the sensor signal of the 3D Hall sensor (11, 29).

8. Actuator (37) for an automated transmission (1) of a motor vehicle, which comprises an apparatus (30) for detecting the position of a shift fork (7) of the transmission (1) that is to be operated directly or indirectly by said actuator, wherein said apparatus (30) has at least the features of any of claims 1 to 6 and is designed to carry out the method according to claim 7.

## Revendications

1. Dispositif (30) comportant un appareil formant capteur à effet Hall (10) pour la détection de la position d'une fourchette de changement de vitesse (7) dans un mécanisme de changement de vitesse (1), dans lequel la fourchette de changement de vitesse (7) est reliée de manière fonctionnelle à une tige de piston (6) d'un piston de changement de vitesse (2) guidé de manière mobile axialement dans un cylindre de changement de vitesse (3) et vient en prise dans un manchon coulissant (8) disposé de manière à pouvoir coulisser axialement sur un arbre de mécanisme (9) afin de faire coulisser ledit manchon coulissant (8) pour l'engagement ou le désengagement d'un rapport de transmission du mécanisme de changement de vitesse (1), dans lequel un unique aimant (13, 28) est disposé sur la fourchette de changement de vitesse (7) en tant qu'émetteur de signaux, **caractérisé en ce qu'**un capteur à effet Hall 3D (11, 29) disposé de manière stationnaire par rapport à l'aimant (13, 28) est prévu en tant que récepteur de signaux, au moyen duquel capteur un champ magnétique généré par l'aimant (13, 28) peut être détecté spatialement, **en ce que** le capteur à effet Hall 3D (11, 29) est connecté à une unité de commande (31) électronique, **et en ce que** l'unité de commande (31) est configurée de telle sorte que, au moyen de celle-ci, la position actuelle de la fourchette de changement de vitesse (7) peut être déterminée et fournie en tant que signal à partir de la position relative respective entre l'aimant (13, 28) et le capteur à effet Hall 3D (11, 29), dans lequel des mouvements linéaires, des mouvements de rotation et des mouvements de pivotement de la fourchette de changement de vitesse (7) peuvent être pris en compte.

2. Dispositif selon la revendication 1, **caractérisé en ce que**, pour l'engagement ou le désengagement d'un rapport de transmission du mécanisme de changement de vitesse (1), un mouvement de pivotement (34) de la fourchette de changement de vitesse (7) est prévu, **et en ce que** l'aimant (28) disposé sur la fourchette de changement de vitesse (7) est conçu de telle sorte que, en coopération avec un capteur à effet Hall 3D (29) associé, la position de la fourchette de changement de vitesse (7) résultant du mouvement de pivotement (34) de la fourchette de changement de vitesse (7) peut être déterminée.

3. Dispositif selon la revendication 1 ou 2, **caractérisé en ce que**, pour l'engagement ou le désengagement d'un rapport de transmission du mécanisme de changement de vitesse (1), un mouvement linéaire (35) de la fourchette de changement de vitesse (7) est prévu, **et en ce que** l'aimant (28) disposé sur la fourchette de changement de vitesse (7) est conçu de telle sorte que, en coopération avec un capteur à effet Hall 3D (11) associé, la position de la fourchette de changement de vitesse (7) résultant du mouvement linéaire de la fourchette de changement de vitesse (7) peut être déterminée, dans lequel un mouvement non linéaire de la fourchette de changement de vitesse (7) superposé au mouvement linéaire peut être compensé par un dimensionnement approprié de l'aimant (28) lors de la détection du champ magnétique, **ou en ce qu'**un tel mouvement parasite peut être éliminé par calcul lors de la détermination de la position de la fourchette de changement de vitesse (7),
dans lequel l'unique aimant (28) est conçu avec une taille suffisante pour que le récepteur de signal détecte le champ magnétique de l'aimant (28) même en cas de faible rotation du piston de changement de vitesse (2) ou de la tige de piston (6) et un signal de mesure suffisamment fort ou précis peut être généré, et dans lequel une détérioration de signal due à la tolérance de palier du piston de changement de vitesse (2) ou de la tige de changement de vitesse est évitée.

4. Dispositif selon l'une des revendications 1 à 3, **caractérisé en ce que** le capteur à effet Hall 3D (11, 29) est disposé au moins partiellement à l'extérieur d'une chambre d'huile (19) du mécanisme de changement de vitesse (1).

5. Dispositif selon la revendication 4, **caractérisé en ce que** le capteur à effet Hall 3D (11, 29) présente une tête de capteur (14) comportant une interface électrique (24) et un doigt de capteur (15) connecté à la tête de capteur (14), dans lequel le doigt de capteur (15) fait saillie à travers une paroi de boîtier (17) dans la chambre d'huile (19) du mécanisme de changement de vitesse (1) en direction de l'aimant (13, 28) associé, **et en ce que** la tête de capteur (14) est disposée sur une face extérieure de la paroi de boîtier (17) et fixée de manière étanche à l'huile par rapport à la chambre d'huile (19).

6. Dispositif selon l'une des revendications 1 à 4, **caractérisé en ce que** le capteur à effet Hall 3D (11, 29) est disposé complètement à l'extérieur de la chambre d'huile (19) du mécanisme de changement de vitesse (1).

7. Procédé permettant la détermination de la position d'une fourchette de changement de vitesse (7) dans un mécanisme de changement de vitesse (1) au moyen d'un appareil formant capteur à effet Hall (10), dans lequel la fourchette de changement de vitesse (7) est reliée de manière fonctionnelle à une tige de piston (6) d'un piston de changement de vitesse (2) guidé de manière mobile axialement dans un cylindre de changement de vitesse (3) et vient en prise dans un manchon coulissant (8) pouvant coulisser axialement sur un arbre de mécanisme (9) afin de faire coulisser ledit manchon coulissant pour l'engagement ou le désengagement d'un rapport de transmission du mécanisme de changement de vitesse (1), et dans lequel un unique aimant (13, 28) est fixé sur la fourchette de changement de vitesse (7), **caractérisé en ce que**, au moyen d'un capteur à effet Hall 3D (11, 29) stationnaire, le champ magnétique de l'aimant (13, 28) est détecté spatialement, lequel aimant, lors d'un mouvement de réglage linéaire et en rotation et lors d'un mouvement de pivotement de la fourchette de changement de vitesse (7), est déplacé avec celle-ci et sa position relative par rapport au capteur à effet Hall 3D (11, 29) stationnaire est ainsi modifiée, **et en ce que** la position actuelle de la fourchette de changement de vitesse (7) est déterminée à partir du signal de capteur du capteur à effet Hall 3D (11, 29).

8. Actionneur (37) pour un mécanisme de changement de vitesse (1) automatisé d'un véhicule automobile, lequel actionneur présente un dispositif (30) permettant la détection de la position d'une fourchette de changement de vitesse (7) du mécanisme de changement de vitesse (1) actionnée directement ou indirectement par celui-ci, dans lequel ledit dispositif (30) présente au moins les caractéristiques de l'une des revendications 1 à 6 et est configuré pour la mise en oeuvre du procédé selon la revendication 7.
